Europäisches Patentamt

European Patent Office

Office européen des brevets

(11) Publication number: **0 169 596**
**B1**

(12) **EUROPEAN PATENT SPECIFICATION**

(45) Date of publication of patent specification: **01.03.89**

(51) Int. Cl.⁴: **H 01 L 39/24**

(21) Application number: **85201025.5**

(22) Date of filing: **26.06.85**

(54) **Method for the manufacture of a superconductor in the form of a single-filament or multi-filament wire or tape.**

(30) Priority: **27.06.84 NL 8402034**

(43) Date of publication of application:
**29.01.86 Bulletin 86/05**

(45) Publication of the grant of the patent:
**01.03.89 Bulletin 89/09**

(84) Designated Contracting States:
**AT BE CH DE FR GB IT LI LU NL SE**

(56) References cited:
**EP-A-0 073 128**
**EP-A-0 140 356**
**FR-A-2 224 903**
**US-A-4 043 028**

(73) Proprietor: **LIPS UNITED B.V.**
**Lipsstraat 52**
**NL-5151 RP Drunen (NL)**

(72) Inventor: **Hoogendam, Pieter**
**Heuvel 51**
**NL-5038 CS Tilburg (NL)**

(74) Representative: **van der Beek, George Frans**
**et al**
**Nederlandsch Octrooibureau Johan de Wittlaan**
**15 P.O. Box 29720**
**NL-2502 LS The Hague (NL)**

Courier Press, Leamington Spa, England.

## Description

The invention relates to a method for the manufacture of a superconductor in the form of a single-filament or multi-filament wire or tape, at least one core material of one or more non-superconducting, powdered intermetallic compounds of at least one element from group VB and at least one element from group IIIA and/or IVA of the periodic system of elements hereinafter referred to as the periodic system being placed in an outer tube of an element or alloy thereof from group VB of the periodic system, which outer tube is placed in a matrix of conducting material and is subjected to a heat reaction treatment in a manner such that a coherent layer with superconducting properties is produced. Such a method is known from US—A—3,926,683.

In this known method the non-superconducting, powdered intermetallic compound, with which the tube of the element or alloy thereof from the said group VB is uniformly filled, has to be compacted in the latter, as a result of which the inner wall of the tube is unevenly stressed and powder grains are embedded in this inner wall so that an irregular tube/powder interface is produced. This effect occurs to an intensified degree if the reduction in diameter of the tube per reduction step is large as, for example, in the case of extrusion. With progressive deformation of the filaments formed in this manner fracture of the filaments, and consequently fracture of the wire, takes place as a result of these irregularities which have occured in the tube/powder interface. Another disadvantage with this method is that the core material situated in the tube and consisting of the powdered intermetallic compound is difficult to deform, especially if this core material is compacted. On progressive deformation this also results in fracture of the filaments. In the method as described very high demands must be made upon the powder with respect to grain size and grain shape, while the achieved ultimate diameter of the filaments remains relatively large.

Another further disadvantage is that the heat treatment or the annealing of the tube material to obtain optimal deformation properties must take place at a rather large diameter because the carrying out of a number of compacting reductions on the tube after the filling with powder, before the filaments thus formed can be processed into a multi-filament composite, is inherent in this process. In this case also the ultimate diameter of the filaments which can be achieved remains relatively large.

The invention intends to eliminate the above-named disadvantages and to provide a method by which superconductors with improved properties are manufactured.

According to the invention this is achieved in a method of the type named in the introduction such that at least one thin-walled inner tube of a material, which does not adversely affect the superconduction, is used, whereby at least said intermetallic compound, which is brought in compact form, is included in said inner tube, and whereby finally said inner tube and said intermetallic compound are included as a whole in the outer tube.

An improved implementation of the method according to the invention is characterised in that said intermetallic compound is mixed with a powdered lubricant or combination of lubricants, the lubricant or combination of lubricants containing preferably an element from group IIIA and/or IVA of the periodic system and none of these lubricants affecting the superconduction adversely.

The compacting of the powder or the powder mixture can take place by filling the separate inner tube or the outer tube, which is already provided with an inner tube, with the powder or the powder mixture and then by drawing the filled tube as a composite rod or subjecting it to some other compacting operation such as vibration or extrusion. In the event that the compacting takes place in a separate inner tube, this inner tube containing the compacted mixture is placed as a whole in the outer tube. The powder mixture, in dependence of its composition, can also be separately compacted and then has sufficient cohesion to be first placed as a rod in the separate inner tube in an intermediate step and subsequently placed in the outer tube or to be placed directly in the outer tube which is already provided with an inner tube.

The invention will be explained in more detail on the basis of a few embodiments with reference to the drawings in which:

Figure 1 shows a view of a single-filament wire according to the invention; and

Figure 2 shows a section through a multi-filament wire according to the invention.

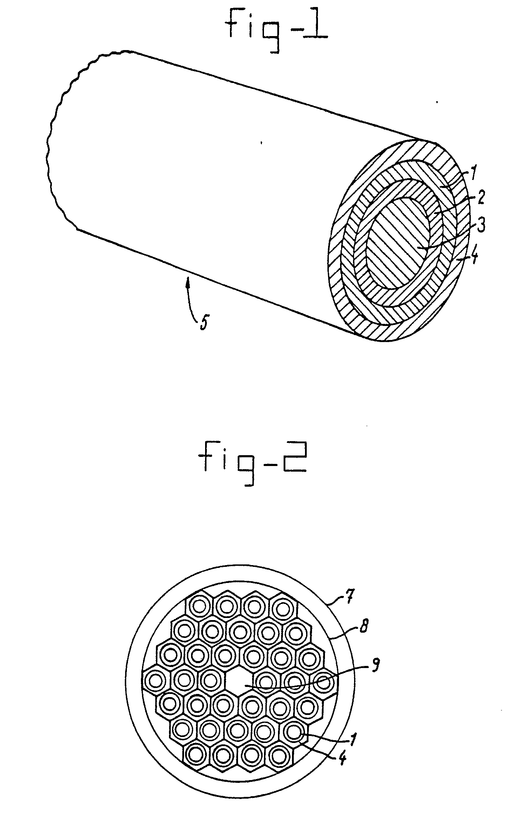

In figure 1, 5 denotes a single-filament wire manufactured according to the invention in which the compacted powder as powder mixture is indicated by 3, the inner tube by 2, the outer tube by 1 and the outer matrix of conducting material by 4.

Figure 2 shows a cross-section through a multi-filament wire in which a large number of single-filament wires is incorporated and in which an outer copper tube is indicated by 7, a copper packing piece by 8, a solid copper central hexagon by 9, the hexagonal outer matrix of copper by 4 and the outer tube of a simple single-filament wire by 1. In the subsequent heat reaction treatment the outer matrices 4 will merge into each other so that the 36 filaments are embedded in a single copper matrix.

The inner tube used in the method according to the invention serves to prevent embedding of powder grains in the inner wall of the outer tube and can act as a holder to compact the powder or the powder mixture therein, such that uneven stressing of the inner wall of the outer tube is prevented also when the reduction in diameter of the tube per reduction step, as for example in the case of extrusion, is large. The heat treatment or the annealing of the material of the outer tube to obtain optimal deformation properties can take place at a smaller diameter before the outer tube is filled with the powder or powder mixture, which is compacted in the inner tube, or is filled with the inner tube and the powder mixture, which is compacted separately with respect to the inner tube. Since it separates the powder from the surrounding outer tube, with which the reaction to form a superconducting compound has to take place, the applied inner tube must also take part in the reaction or dissolve without impairing the reaction.

The non-superconducting, powdered intermetallic compound, which is included in compacted form in the inner tube, comprises at least one element from group IIIA and/or IVA and also at least one element from group VB of the periodic system as indicated before. When attaining the temperature of the mechanical deformation and the one of the heat reaction treatment said intermetallic compound is present as solid phase in the core of the filaments and provides, as a kind of skeleton material, structure thereto. Because said intermetallic compound is unstable at the temperature of the heat reaction treatment, it also acts as a source for the said element from group IIIA and/or IVA of the periodic system, which takes part in the reaction into the superconducting compound.

In the method according to the invention the deformation properties of the core material are improved by mixing the non-superconducting, powdered intermetallic compound with a lubricant. Said lubricant does not take part in, nor interfere in, the reaction during the heat treatment in which the superconducting compound layer is formed, or the lubricant does take part in this reaction without adversely affecting the superconducting properties of the compound formed. This lubricant is used with considerable advantage in the powder mixture in order to make a homogeneous deformation of this powder mixture possible and acts between the grains of the other substances. In the case of a lubricant which can be plastically deformed the grains are embedded in this lubricant, as a result of which clotting and formation of structures are prevented. In the case of a lubricant which consists of hard spherical grains (such as aluminium oxide) or platelets which can shear (such as graphite), the grains of the other substances can also move along each other as a result of which clotting and formation of structures are again prevented. Use of a mixture of lubricants can therefore be very expedient.

If compacting of the powder or powder mixture takes place outside the said outer tube of an element or alloy thereof from the group VB of the periodic system, for example niobium or a niobium alloy, then the powder or powder mixture, which is compacted in the inner tube, together with this surrounding inner tube is placed as a rod in the outer tube; or when the powder or powder mixture is compacted separately with respect to the inner tube, it is placed together with said inner tube as a rod in the said outer tube. This outer tube is subsequently sunk around the said rod. The whole is possibly subjected to still further drawing and the rod thus formed can be processed into a single-filament or multi-filament composite. In this process the filaments embedded in the matrix can be considerably reduced in diameter down to, for example, 10 to 20 μm without filament degradation occurring. The subsequent heat reaction treatment may take place at a temperature of 600—800°C.

Copper or also tin, can, for example, be used as the material for the inner tube in which the powder or powder mixture is compacted and which takes part in the reaction to form a superconducting compound.

As the lubricant in the powder mixture tin can be used in an amount of 5 to 60 weight per cent of the powder mixture. If the powder mixture consists of $NbSn_2$ with tin as lubricant, the quantity of tin, present as free tin and bound in the intermetallic compound, is a maximum of 85 weight per cent of the mixture. Other lubricants, for example tantalum, aluminium oxide, or graphite or combinations thereof, are also conceivable.

As already described in US—A—3,926,683 the presence of free tin can give rise to problems during extrusion or other operations in which the temperature exceeds the melting point of tin. This problem is much less serious in the method of the invention since the inner tube of copper present protects the niobium against the corrosive fluid tin. A bronze layer formed at that point during, for example, extrusion, disintegrates in the subsequent wire processing. A complete fluid phase in the core of the filaments is not formed because the compacted powder mixture includes a non-melting compound. If problems arise, when tin is used as lubricant, as a result of its melting, the tin lubricant can be wholly or partly replaced by another lubricant so that a temperature rise during processing into wire does not give rise to any problems. The quantity of tin which is present then decreases so that in the heat reaction treatment the yield of superconductor is lower.

As a kind of skeleton material, the presence of a non-melting component in the compacted powder mixture imparts a structure to the powder core of the filaments both during the mechanical deforming and during the heat reaction treatment. As a result a uniform superconducting layer is formed on the inside of the outer tube during the heat reaction treatment because the powder core of the filaments does not become completely fluid.

In the event that the intermetallic compound $NbSn_2$ is taken as the non-melting component of the powder core and tin as lubricant in a copper inner tube with niobium as outer tube, the free tin in contact with the copper reacts to form bronze during the heat reaction treatment, after which the reaction with the niobium of the outer tube takes place. In these reactions tin is subsequently supplied from the fluid free tin in the free space between the powder particles of the skeleton material and from the solid $NbSn_2$ because the latter becomes unstable and thereby subsequently supplies tin.

If the free tin is replaced as lubricant wholly or partly by a material which is inert during the heat reaction treatment or by a material that does not adversely affect the superconduction, the reaction sequence remains the same but the quantity of superconductor formed decreases.

The best yield of superconductor is therefore obtained if both the skeleton material and the lubricant take part in the reaction as in the case of $NbSn_2$ and tin lubricant. If the melting of the tin gives rise to problems during the mechanical deformation, for example during extrusion, the tin must be completely or partly replaced by another lubricant.

To the powder mixture elements or compounds thereof can be added which accelerate the reaction and/or allow it to proceed at lower temperature and/or improve the superconducting properties of the compound layer formed, provided these elements or compounds thereof are in a state (phase) such that, upon mechanical processing, e.g. extrusion, no sintering takes place with other substances in the powder mixture through a possible rise in temperature.

Thus, in the method in which the inner tube does not consist of copper, copper powder is added as a reaction accelerator to the powder mixture in a quantity of at least 0.1 weight per cent of the mixture. In the method in which the inner tube consists of copper, copper is as a result in general present in a quantity of more than 10 weight per cent of the mixture and no further copper needs to be added. Another element or compound thereof which accelerates the reaction and/or allows it to proceed at lower temperature, and/or improves the superconducting properties can also be added in addition. In the event that the inner tube consists of a material which takes part in the reaction or does not adversely affect the latter (e.g. tin) and/or improves the superconducting properties, copper can still be added in many cases as a reaction accelerator to the powder mixture.

In case of temperature rise during mechanical processing, for example extrusion, then said copper in the powder mixture must be present in another state, e.g. as n-bronze, as otherwise sintering takes place in the powder mixture.

From DE—A—2,620,271 a method is known in which a core material of an alloy with high tin content is placed in an inner tube of copper, after which the whole is placed in an outer tube of niobium. The copper tube is in this case used for completely different reasons, viz. to smooth out the difference in mechanical properties, whereas the tin content in the core material must be below 25 atomic per cent in order finally to form a uniform $Nb_3Sn$ layer. The reaction in which this layer is formed is then a reaction between solid substances.

In the method according to the invention the mixture of powdered intermetallic compound and lubricant already has mechanical properties such that deformation in the outer niobium tube is very feasible. The copper inner tube acts as a holder for compacting the powder mixture therein and to prevent the embedding of powder grains in the inner wall of the outer tube. The choice of copper as the material for this holder is a good choice in view of the participation of this element as a reaction accelerator in the formation of the $Nb_3Sn$ layer. The said copper inner tube can be provided with a further inner tube of tin. This additional inner tube of tin provides an extra protection for the inner wall of the outer tube and increases the quantity of tin present.

The use of the intermetallic compound and tin as lubricant between the grains thereof causes the quantity of tin present, which can be used in the formation of the $Nb_3Sn$ layer, to rise to, for example, three times the level stated as the optimum level in DE—A—2,620,271. The formation of an even $Nb_3Sn$ layer is not at risk because the reaction takes place as a sort of substance/ solid substance reaction. This means that during this reaction the powder structure of the core remains intact, doses of tin being additionally supplied from this structure to the reaction because the $NbSn_2$ destabilises.

The quantity of tin which is used is also considerably higher compared with the method in US Patent 3,926,683. This is due on the one hand to the fact that a compacted powder mixture is the starting point and on the other hand, to the fairly large quantity of free tin which can rise to approximately 80 atomic per cent. In addition, as a result of the smooth interface between the niobium of the outer tube and the powder mixture, which may still be present in the inner tube, a very regular layer growth of the superconducting compound is produced in the heat reaction treatment so that in the design of the superconductor a very thin diffusion barrier may be sufficient without the copper matrix being contaminated by reaction with tin which is derived from the powder mixture.

This method according to the invention is thus unusually advantageous as a result of the fact that a superconductor which has very high critical current density is obtained by means of a very reliable production process.

## Claims

1. A method for the manufacture of a superconductor in the form of a single-filament or multi-filament wire or tape, at least one core material (3) of one or more non-superconducting, powdered intermetallic compounds of at least one element from group VB and at least one element from group IIIA and/or IVA of the periodic system being placed in an outer tube (1) of an element or alloy thereof from group VB of the periodic system, which outer tube is placed in a matrix (4) of conducting material and is subjected to a heat reaction treatment in a manner such that a coherent layer with superconducting properties is produced, characterized in that at least one thin-walled inner tube (2) of a material, which does not adversely affect the superconduction, is used, whereby at least said intermetallic compound, which is brought in compact form, is included in said inner tube, and whereby finally said inner tube and said intermetallic compound are included as a whole in the outer tube.

2. A method according to claim 1, characterized in that said intermetallic compound is mixed with a powdered lubricant or combination of lubricants, the lubricant or combination of lubricants containing preferably an element from group IIIA and/or IVA of the periodic system and none of these lubricants affecting the superconduction adversely.

3. A method according to claim 1 or 2, characterized in that the compacting takes place by filling the separate inner tube or by filling the outer tube, already provided with an inner tube, with the intermetallic compound or the powder mixture and subjecting the filled tube to a compacting operation.

4. A method according to claim 2, characterized in that the powder mixture is separately compacted and is placed as a rod either first in the separate inner tube in an intermediate step and subsequently in the outer tube or directly in the outer tube, which is already provided with an inner tube.

5. A method according to claims 2, 3 or 4, in which $NbSn_2$ is used for the said intermetallic compound and niobium or alloy thereof is used for the outer tube, a superconducting layer of $Nb_3Sn$ being produced by the heat reaction treatment, characterized in that tantalum, tin, aluminium oxide, graphite, or a combination thereof is used for the lubricant in an amount of 5 to 60 weight per cent of the powder mixture.

6. A method according to one of the preceding claims, characterized in that copper is used as material of the inner tube.

7. A method according to claim 5 or 6, characterized in that a further inner tube of tin is placed in the inner tube before the mixture is introduced.

8. A method according to one of the preceding claims, characterized in that elements or compounds thereof are added to the powder mixture, which addition accelerates the reaction and/or allows it to proceed at lower temperature and/or improves the superconducting properties of the layer formed.

**Patentansprüche**

1. Verfahren zur Herstellung eines Supraleiters in Form eines ein- oder mehrfädigen Drahts oder Bands, wobei mindestens ein Kernmaterial (3) aus einer oder mehreren nicht-supraleitenden pulvrigen intermetallischen Verbindungen von mindestens einem Element der Gruppe VB und mindestens einem Element der Gruppe IIIA und/ oder IVA des periodischen Systems in ein äusseres Rohr (1) aus einem Element der Gruppe VB des periodischen Systems oder einer Legierung davon angeordnet wird, dieses äussere Rohr in eine Matrix (4) aus leitendem Material angeordnet und auf solche Weise durch thermische Reaktion behandelt wird, dass eine kohärente Schicht mit supraleitenden Eigenschaften gebildet wird, dadurch gekennzeichnet, dass mindestens ein dünnwandiges inneres Rohr (2) aus einem die Supraleitung nicht beeinträchtigenden Material verwendet wird, wobei mindestens die genannte intermetallische Verbindung, die in kompakter Form zugeführt wird, in diesem inneren Rohr eingeschlossen ist, und wobei schliesslich dieses innere Rohr und diese intermetallische Verbindung als Ganzes im äusseren Rohr eingeschlossen sind.

2. Verfahren nach Anspruch 1, dadurch gekennzeichnet, dass die intermetallische Verbindung mit einem pulvrigen Schmiermittel oder einer Kombination von pulvrigen Schmiermitteln gemischt wird, wobei das Schmiermittel oder die Kombination von Schmiermitteln vorzugsweise ein Element der Gruppe IIIA und/oder IVA des periodischen Systems enthält und keines dieser Schmiermittel die Supraleitung beeinträchtigt.

3. Verfahren nach Anspruch 1 oder 2, dadurch gekennzeichnet, dass die Kompaktierung stattfindet, indem man das separate innere Rohr oder das bereits mit einem inneren Rohr versehene äussere Rohr mit der intermetallischen Verbindung oder der Pulvermischung füllt und das gefüllte Rohr einem Kompaktierungsvorgang unterzieht.

4. Verfahren nach Anspruch 2, dadurch gekennzeichnet, dass man die Pulvermischung separat kompaktiert und, als Stab, entweder in einem Zwischenschritt zuerst in das separate innere Rohr und danach in das äussere Rohr oder direkt in das bereits mit einem inneren Rohr versehene äussere Rohr einsetzt.

5. Verfahren nach den Ansprüchen 2, 3 oder 4, bei welchem man als intermetallische Verbindung $NbSn_2$ und für das äussere Rohr Niob oder eine Legierung davon verwendet, wobei eine supraleitende Schicht von $Nb_3Sn$ durch die thermische Reaktion gebildet wird, dadurch gekennzeichnet, dass für das Schmiermittel Tantal, Zinn, Aluminiumoxid, Graphit oder eine Kombination davon in einer Menge von 5 bis 60 Gew.-% der Pulvermischung verwendet wird.

6. Verfahren nach einem der vorangehenden Ansprüche, dadurch gekennzeichnet, dass als Material des inneren Rohrs Kupfer verwendet wird.

7. Verfahren nach den Ansprüchen 5 oder 6, dadurch gekennzeichnet, dass ein weiteres inneres Rohr aus Zinn in das innere Rohr angeordnet wird, bevor die Mischung eingeführt wird.

8. Verfahren nach einem der vorangehenden Ansprüche, dadurch gekennzeichnet, dass man der Pulvermischung Elemente oder Verbindungen davon beigibt, wobei diese Beigabe die Reaktion beschleunigt und/oder ihren Ablauf bei niedrigerer Temperatur erlaubt und/oder die supraleitenden Eigenschaften der gebildeten Schicht verbessert.

**Revendications**

1. Procédé de fabrication d'un supraconducteur en forme de fil ou de ruban monofilamentaire ou multifilamentaire, au moins un matériau de noyau (3) fait d'un ou plusieurs composés intermétalliques non supraconducteurs pulvérulents d'au moins un élément du groupe VB et d'au moins un élément du groupe IIIA et/ou IVA du système périodique étant disposé dans un tube extérieur (1) fait d'un élément du groupe VB du système périodique ou d'un alliage de celui-ci, lequel tube extérieur est disposé dans une matrice (4) de matériau conducteur et soumis à un traitement de réaction thermique de manière à produire une couche cohérente ayant des propriétés supraconductrices, caractérisé en ce qu'on utilise au moins un tube intérieur (2) à paroi mince fait d'un matériau qui n'affecte pas la supraconductivité de façon adverse, au moins le composé intermétallique, que l'on amène sous forme compacte, étant inclus dans le tube intérieur, et le tube intérieur et le composé intermétallique étant finalement inclus comme un tout dans le tube extérieur.

2. Procédé selon la revendication 1, caractérisé en ce qu'on mélange le composé intermétallique avec un lubrifiant pulvérulent ou une combinaison de lubrifiants pulvérulents, le lubrifiant ou la combinaison de lubrifiants contenant de préférence un élément du groupe IIIA et/ou IVA du système périodique et aucun de ces lubrifiants n'affectant la supraconductivité de façon adverse.

3. Procédé selon la revendication 1 ou 2, caractérisé en ce qu'on effectue le compactage en remplissant de composé intermétallique ou de mélange pulvérulent le tube intérieur séparé ou le tube extérieur préalablement pourvu d'un tube intérieur et en soumettant le tube rempli à une opération de compactage.

4. Procédé selon la revendication 2, caractérisé en ce l'on compacte séparément le mélange pulvérulent et qu'on le dispose comme une tige soit au cours d'une étape intermédiaire d'abord dans le tube intérieur séparé et ensuite dans le tube extérieur ou bien directement dans le tube extérieur déjà pourvu d'un tube intérieur.

5. Procédé selon les revendications 2, 3 ou 4 dans lequel on utilise NbSn$_2$ comme composé intermétallique et du niobium ou un alliage de celui-ci pour le tube extérieur, une couche supraconductrice de Nb$_3$Sn étant produite par le traitement de réaction thermique, caractérisé en ce l'on utilise comme lubrifiant du tantale, de l'étain, de l'oxyde d'aluminium, du graphite ou une combinaison de ceux-ci en une quantité de 5 à 60% en poids du mélange pulvérulent.

6. Procédé selon l'une des revendications précédentes, caractérisé en ce l'on utilise du cuivre comme matériau du tube intérieur.

7. Procédé selon la revendication 5 ou 6, caractérisé en ce l'on dispose un autre tube intérieur en étain dans le tube intérieur avant d'introduire le mélange.

8. Procédé selon l'une des revendications précédentes, caractérisé en ce l'on ajoute au mélange pulvérulent des éléments ou des composés de ceux-ci, cette addition accélérant la réaction et/ou lui permettant de se produire à plus basse température et/ou améliorant les propriétés supraconductrices de la couche formée.

EP  0 169 596  B1

fig-1

fig-2